(19) Europäisches Patentamt
European Patent Office
Office européen des brevets

(11) **EP 2 286 512 B1**

(12) **EUROPÄISCHE PATENTSCHRIFT**

(45) Veröffentlichungstag und Bekanntmachung des Hinweises auf die Patenterteilung:
**04.04.2012 Patentblatt 2012/14**

(21) Anmeldenummer: **09753784.9**

(22) Anmeldetag: **11.05.2009**

(51) Int Cl.:
**H03K 9/08** (2006.01)   **G01R 19/00** (2006.01)

(86) Internationale Anmeldenummer:
**PCT/EP2009/055636**

(87) Internationale Veröffentlichungsnummer:
**WO 2009/144129 (03.12.2009 Gazette 2009/49)**

(54) **VERFAHREN ZUR BESTIMMUNG DES GLEICHANTEILS EINES PERIODISCHEN SIGNALS**

METHOD FOR DETERMINING THE OFFSET OF A PERIODIC SIGNAL

PROCÉDÉ DE DÉTERMINATION DE LA COMPOSANTE CONTINUE D'UN SIGNAL PÉRIODIQUE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **30.05.2008 AT 8782008**

(43) Veröffentlichungstag der Anmeldung:
**23.02.2011 Patentblatt 2011/08**

(73) Patentinhaber: **SIEMENS AKTIENGESELLSCHAFT**
**80333 München (DE)**

(72) Erfinder: **HALLAK, Jalal**
**A-1220 Wien (AT)**

(74) Vertreter: **Maier, Daniel Oliver**
**Siemens AG**
**Postfach 22 16 34**
**80506 München (DE)**

(56) Entgegenhaltungen:
**DE-A1- 2 454 601    DE-A1- 3 900 796**
**JP-A- 57 048 826    US-A- 4 109 308**
**US-A- 5 452 198**

## Beschreibung

## Technisches Gebiet

Die Erfindung betrifft ein Verfahren zur Bestimmung des Gleichanteils eines periodischen Signals

## Stand der Technik

Der Gleichanteil $\overline{u}$ (Gleichwert) eines periodischen Signals u errechnet sich gemäß:

$$\overline{u} = \int_{0}^{T} u\,dt$$

als Integral über eine Periodendauer T des Signals u. Demnach enthält ein Signal keinen Gleichanteil wenn die positiven und negativen Signal-Zeitflächen über eine Periodendauer gegenseitig aufheben. Dies stellt den Fall einer sogenannten Wechselspannung dar.

In technischen Anwendungen ist die Bestimmung des Gleichwerts eines Signals eine häufige Aufgabenstellung. Diese Aufgabe wird häufig durch den Einsatz eines Verfahrens, welches anstatt einer Integration eine Summenbildung zur Gleichwertbestimmung einsetzt gelöst.

Der Gleichanteil $\overline{u}$ bestimmt sich somit gemäß:

$$\overline{u} = \sum u(t)\Delta t$$

wobei die kontinuierliche Integration des Signals u über eine Periodendauer T in eine Summenbildung über die Signal-Zeitinkrementfächen u(t)*$\Delta t$ übergeht.

Die Genauigkeit einer Gleichwertbestimmung nach diesem Verfahren ist unter anderem von der Größe der Zeitinkremente $\Delta t$ abhängig, wobei möglichst kleine Zeitinkremente $\Delta t$ angestrebt werden.

Ein häufig zur Gleichanteilbestimmung eingesetztes Verfahren integriert (summiert) das Eingangssignal über eine volle Periodendauer T mittels eines Integrators. Der nach einer vollen Periodendauer T im Integrator gespeicherte Wert stellt den Gleichanteil dieser Periode dar. Mit dem zeitlichen Beginn der nächsten Periode wird der Integrator zurückgesetzt (der gespeicherte Wert gelöscht) und die Messung beginnt von neuem. Mit diesem Verfahren wird der Gleichanteil jeder einzelnen Periode bestimmt.

Wird die Amplitude des Signals, dessen Gleichanteil bestimmt werden soll, während der Bestimmung verändert (gesteigert oder reduziert), so zeigt dieses Gleichanteilbestimmungsverfahren während der Amplitudenveränderung jedoch einen Gleichanteil an, da in diesem Fall jede zeitlich nachfolgende Halbwelle eine größere (bzw. kleinere) Amplitude aufweist als die vorhergehende Halbwelle mit entgegengesetzter Polarität. Die positiven und negativen Halbwellen sind während der Amplitudenveränderung jeweils ungleich, sodass im Fall einer Amplitudenerhöhung ein negativer Gleichanteil und im Fall einer Amplitudenverringerung ein positiver Gleichanteil von diesem Gleichanteilsbestimmungsverfahren ermittelt wird, je nachdem zum Zeitpunkt welcher Halbperiode (positve oder negative) der Anstieg, bzw. der Abfall des Pegel beginnt. Dieser, nur während einer Amplitudenveränderung auftretender Gleichanteil kann sich für bestimmte Regelungen, besonders für Anwendungen in der Wechselrichtertechnik nachteilig auswirken. In der Wechselrichtertechnik werden Regelschaltungen, unter anderem zur Beeinflussung des Gleichteils des Ausgangssignals, eingesetzt, deren Regelgeschwindigkeiten so hoch sind, dass bereits die während nur einiger weniger Periodendauern (typischerweise von 50Hz oder 60Hz Netzspannung) auftretenden Gleichwerte einen Regelvorgang auslösen welcher zu unerwünschten Schwingungen des Regelkreises führen kann.

Aus der DE 39 00 796 A1 ist ein Halbwellenverfahren zur Bestimmung des Gleichanteils eines periodischen Transformatorstromes bekannt. Die Schaltung besteht aus einem Integrator, dem zwei parallelgeschaltete Analogspeicher nachgeschaltet sind. Die Ausgänge der beiden Analogspeicher sind auf einen Summierer geführt. Diesem Summierer ist ein weiterer Analogspeicher nachgeschaltet. Das Ausgangssignal dieses Analogspeichers dient als Korrektursignal für eine Umrichter-Steuerelektronik. Für die Feststellung eines Stromnulldurchgangs des Transformatorstromes ist ein Steuerwerk vorgesehen, das die Betriebsart der Analogspeicher bestimmt. Dieses Verfahren zeigt während einer Amplitudenänderung einen alternierenden Gleichwert an.

## Darstellung der Erfindung

Der Erfindung liegt daher die Aufgabe zugrunde, ein Verfahren zur Bestimmung des Gleichanteils eines periodischen Signals anzugeben, welches den während der Veränderung der Amplitude eines periodischen Signals entstehenden Gleichanteil kompensiert.

Die Aufgabe wird durch ein Verfahren mit den Merkmalen des Anspruchs 1 und durch ein Verfahren mit den Merkmalen des Anspruchs 2 gelöst.

Zur Periodizitätserkennung kann beispielsweise eine sogenannte Nulldurchgangserkennung herangezogen werden.

Damit ist der Vorteil erzielbar, dass der im Fall der Veränderung der Amplitude des Signals auftretende Gleichanteil kompensiert wird und nur der Gleichanteil des Signals bestimmt wird, der auch bei konstanter Amplitude durch das Integralverfahren bestimmt wird.

Der wesentliche Vorteil des erfindungsgemäßen Verfahrens liegt darin, dass auf der Bestimmung des Gleichanteils beruhende Regelungen (insbesondere in Stromrichter- bzw. Wechselrichteranwendungen) durch die bei Amplitudenänderungen kurzfristig auftretenden Gleichanteilswerte nicht mehr zu Stellgrößenänderungen veranlasst werden, welche nicht erforderlich sind und welche zu Schwingungen der Regelkreises führen können.

Das erfindungsgemäße Verfahren ist für die Anwendung bei sinusförmigen Signalen besonders vorteilhaft, da bei sinusförmigen Signalen die Erkennung der Periodendauer (bzw. des Periodenanfangs und Endes) besonders einfach erfolgen kann.

Die Anwendung des erfindungsgemäßen Verfahrens ist auf beliebige periodische Signale möglich, allenfalls ist die Erkennung der Periodizität des Signals auf das jeweilige Signal abzustimmen.

Das erfindungsgemäße Verfahren eignet sich einerseits zum konkreten Aufbau einer das Verfahren ausführenden elektronischen Schaltung mittels diskreter elektronischer Bauelemente, andererseits auch zur Realisation mittels Software, wobei die kontinuierliche Integration naturgemäß in die Verarbeitung zeitlich diskreter Signalwerte übergeht. Durch geeignete Wahl der Abtastfrequenz kann auch bei Realisation mittels Software eine der diskreten Ausführungsform gleichwertige Lösung erzielt werden. Beliebige Mischformen aus diskreten elektronischen Bauelementen und Software sind ebenfalls möglich.

Der konkrete Aufbau einer das erfindungsgemäße Verfahren ausführenden Schaltung muss neben den beschriebenen Komponenten (Integrator, Periodizitätserkennung, Summierung) noch Baugruppen umfassen, welche den Integrator jeweils nach einem Integrationsvorgang wieder rücksetzen und das Integrationsergebnis (im allgemeinen als Spannungspegel repräsentiert) kurzfristig speichern (Sample&Hold).

Eine weitere Ausgestaltung der Erfindung sieht deshalb vor, das durch Addition der Ausgangssignale der beiden Integratoren gebildete, den Gleichanteil des Eingangssignals darstellende Signal bei Erkennen einer Amplitudenänderung in einer Speichervorrichtung zu speichern und für eine bestimmte Zeitdauer weiterhin als gültiges Ausgangssignal anzusehen. Dazu werden die gespeicherten Ausgangssignale der beiden Integratoren (jeweils nach einer vollen Periode) mittels einer Vergleichervorrichtung (Komparator) miteinander verglichen. Besteht eine Differenz, so ist in der letzen Messzeit (Periodendauer) eine Amplitudenänderung des Eingangssignals aufgetreten. Die Vergleichervorrichtung steuert bei Erkennen einer Amplitudenänderung ein Zeitglied (Mono Flip Flop) an. Dieses Zeitglied steuert die Speichervorrichtung für eine von diesem Zeitglied bestimmte Zeitdauer in einer Weise an, dass die Speichervorrichtung den in ihr gespeicherten Wert (der den zuletzt bestimmten Wert des Gleichanteils des Eingangssignals darstellt) für diese Zeitdauer als Ausgangswert konstant hält.

Dadurch ist der Vorteil erzielbar, dass fälschlich auftretende Schwankungen des ermittelten Gleichanteils von einer Regelschaltung ferngehalten werden und diese Regelschaltung somit nicht zu unnötigen Stellgrößenänderungen veranlasst wird.

Die aus dem Stand der Technik bekannte Halbwellenintegration sieht die Verwendung nur eines Integrators vor, wobei beide Halbwellen (positive und negative Halbwelle) von diesem einen Integrator getrennt integriert werden und das Ergebnis der ersten (beispielsweise der positiven) Halbwelle in einer Speichervorrichtung (Sample & Hold) abspeichern bis das Ergebnis der zweiten Halbwelle ermittelt und ebenfalls in einer weiteren Speichervorrichtung abgespeichert wurde. Anschließend werden die in den beiden Speichervorrichtungen abgespeicherten Ergebnisse miteinander addiert und somit der Gleichanteil der gesamten Periode ermittelt. Dieses Verfahren ermittelt den Gleichanteil um die Zeitdauer einer Halbperiode schneller als ein Verfahren mit einem Integrator, welcher die gesamte Periode integriert. Dieses Verfahren zeigt während der Amplitudenänderung einen alternierenden Gleichwert an.

Eine erste Ausführungsform des erfindungsgemäßen Verfahrens bildet dieses Halbwellenintegrationsverfahren weiter, wobei eine dritte und eine vierte Speichervorrichtung (Sample & Hold) vorgesehen sind, welche das Ausgangssignal eines Halbwellenintegrationsverfahrens als Eingangssignal erhalten und eine dieser Speichervorrichtungen mit einer Verzögerung zwischen Null und einem Viertel der Periodendauer das Eingangssignal erfasst und abspeichert und die zweite dieser Speichervorrichtungen mit einer Verzögerung zwischen einem Viertel und der Halben Periodendauer das Eingangssignal erfasst und abspeichert. Das den Gleichanteil des zu untersuchenden Signals darstellende Ausgangssignal wird mittels Summierung aus den Ausgangssignalen der beiden (zusätzlichen) Speichervorrichtungen gebildet.

Dadurch ist der Vorteil erzielbar, einerseits das den Gleichanteil schneller ermittelnde Halbwellenintegrationsverfahren einsetzen zu können, als auch bei Amplitudenänderungen keinen alternierenden Gleichanteil ausgewiesen zu bekommen und eine auf dieser Meßgröße beruhende Regelung nicht zu unnötigen Stellgrößenänderungen veranlassen.

Dieses verbesserte Halbwellenintegrationsverfahren bedingt allerdings, dass zu Beginn der Amplitudenänderung für die Zeit einer halben Periode ein Gleichanteil angezeigt wird. In weiterer Ausgestaltung der Erfindung ist deshalb vorgesehen, das durch Addition der Ausgangssignale der dritten und vierten Speichervorrichtung gebildete, den Gleichanteil des Eingangssignals darstellende Signal bei Erkennen einer Amplitudenänderung in einer fünften Speichervorrichtung zu speichern und für eine bestimmte Zeitdauer weiterhin als gültiges Ausgangssignal anzusehen. Dazu werden die gespeicherten Ausgangssignale der dritten und vierten Speichervorrichtung (jeweils nach einer vollen Periode) mittels einer Vergleichervorrichtung (Komparator) miteinander verglichen. Besteht eine Differenz, so ist in der letzten Messzeit (Periodendauer) eine Amplitudenänderung des Eingangssignals aufgetreten. Die Vergleichervorrichtung steuert bei Erkennen einer Amplitudenänderung ein Zeitglied (Mono Flip Flop) an. Dieses Zeitglied steuert die fünfte Speichervorrichtung für eine von diesem Zeitglied bestimmte Zeitdauer in einer Weise an, dass die fünfte Speichervorrichtung den in ihr gespeicherten Wert (der den zuletzt bestimmten Wert des Gleichanteils des Eingangssignals darstellt) für diese Zeitdauer als Ausgangswert konstant hält.

Dadurch ist der Vorteil erzielbar, dass fälschlich auftretende Schwankungen des ermittelten Gleichanteils von einer Regelschaltung ferngehalten werden und diese Regelschaltung somit nicht zu unnötigen Stellgrößenänderungen veranlasst wird, wobei der Vorteil des rascher reagierenden Halbwellenintegrationsverfahrens beibehalten wird..

Weiters ist es vorteilhaft, das erfindungsgemäße Verfahren mittels eines Computers, besonders mittels eines sogenannten Mikrokontrollers auszuführen. Die das Verfahren ausführenden Baugruppen eignen sich gut dafür, mittels eines Mikrokontrollers umgesetzt zu werden, da insbesondere der verwendete Integrator und die Speichervorrichtungen (Sample&Hold) in dieser Ausführungsform die ansonsten unvermeidlichen Toleranzen und Signalverluste nicht aufweisen.

## Kurzbeschreibung der Zeichnungen

Es zeigen beispielhaft:

**Fig. 1** Blockschaltbild einer Gleichanteilsbestimmungsschaltung nach dem Integrationsverfahren.
**Fig. 2** Simulation der Signalverläufe in einer Gleichanteilsbestimmungsschaltung nach dem Integrationsverfahren bei einem Eingangssignal ohne Gleichanteil
**Fig. 3** Simulation der Signalverläufe in einer Gleichanteilsbestimmungsschaltung nach dem Integrationsverfahren bei einem Eingangssignal mit Gleichanteil.
**Fig. 4** Simulation der Signalverläufe in einer Gleichanteilsbestimmungsschaltung nach dem Integrationsverfahren bei einem Eingangssignal mit ansteigender Amplitude.
**Fig. 5** Simulation der Signalverläufe in einer Gleichanteilsbestimmungsschaltung nach dem Integrationsverfahren bei einem Eingangssignal mit abfallender Amplitude.
**Fig. 6** Simulation der Signalverläufe in einer Gleichanteilsbestimmungsschaltung nach dem Integrationsverfahren bei einem Eingangssignal mit ansteigender Amplitude und Gleichanteil.
**Fig. 7** Blockschaltbild einer erfindungsgemäßen Gleichanteilsbestimmungsschaltung nach einem

Halbwellenintegrationsverfahren mit zwei zusätzlichen Speichervorrichtungen.
**Fig. 8** Simulation der Signalverläufe in einer erfindungsgemäßen Gleichanteilsbestimmungsschaltung nach einem Halbwellenintegrationsverfahren mit zwei zusätzlichen Speichervorrichtungen bei einem Eingangssignal mit ansteigender Amplitude.
**Fig. 9** Simulation der Signalverläufe in einer erfindungsgemäßen Gleichanteilsbestimmungsschaltung nach einem Halbwellenintegrationsverfahren mit zwei zusätzlichen Speichervorrichtungen bei einem Eingangssignal mit abfallender Amplitude
**Fig. 10** Simulation der Signalverläufe in einer erfindungsgemäßen Gleichanteilsbestimmungsschaltung nach einem Halbwellenintegrationsverfahren mit zwei zusätzlichen Speichervorrichtungen bei einem Eingangssignal mit ansteigender Amplitude und Gleichanteil von 10% der Amplitude
**Fig. 11** Simulation der Signalverläufe in einer erfindungsgemäßen Gleichanteilsbestimmungsschaltung nach einem Halbwellenintegrationsverfahren mit zwei zusätzlichen Speichervorrichtungen bei einem Eingangssignal mit abfallender Amplitude und Gleichanteil von 10% der Amplitude
**Fig. 12** Blockschaltbild einer erfindungsgemäßen Gleichanteilsbestimmungsschaltung wie in Fig. 11, erweitert um Mittel zur Unterdrückung des Einschwingimpulses.
**Fig. 13** Simulation der Signalverläufe in einer erfindungsgemäßen Gleichanteilsbestimmungsschaltung wie in

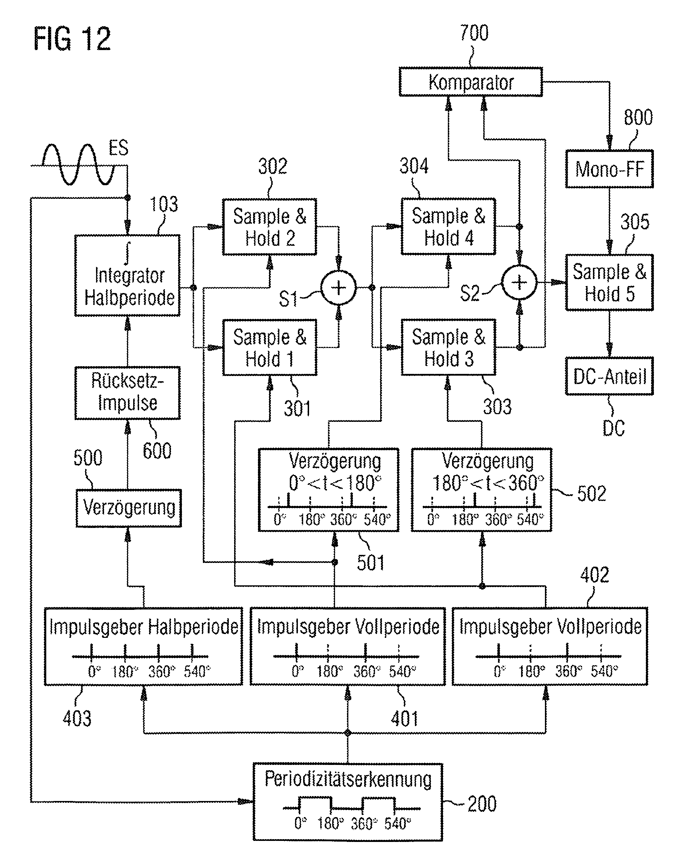

Fig. 12 bei einem Eingangssignal mit ansteigender Amplitude und Gleichanteil von 10% der Amplitude.

## Ausführung der Erfindung

Die in den Figuren dargestellten Signalverläufe sind beispielhaft zur Erläuterung des erfindungsgemäßen Verfahrens, besonders die in den Signalverläufen angegebenen Spannungswerte dienen ausschließlich der besseren Verständlichkeit der Erläuterungen. In allen Figuren, welche Signalverläufe dargestellt werden, stellt die waagrechte Achse die Zeit dar. Das erfindungsgemäße Verfahren ist für beliebige Pegel und Frequenzen des Eingangssignals anwendbar.

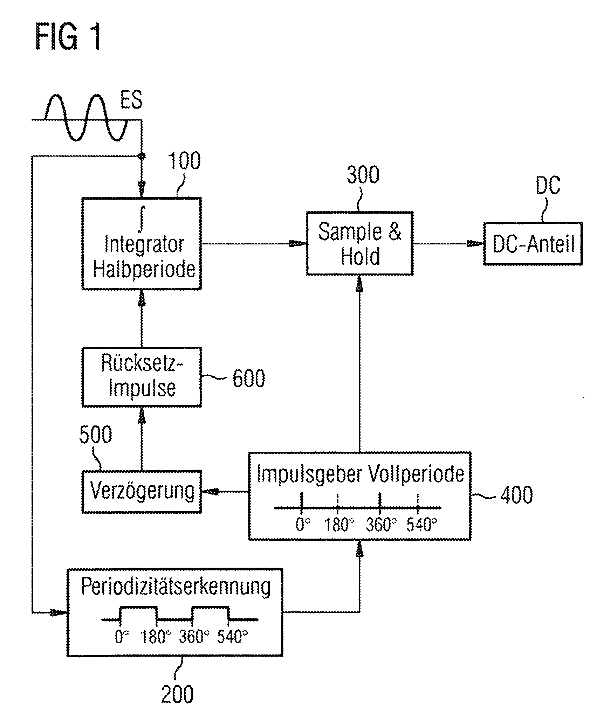

**Fig. 1** zeigt beispielhaft und schematisch ein Blockschaltbild einer Gleichanteilsbestimmungsschaltung nach dem Integrationsverfahren wie es aus dem Stand der Technik bekannt ist. Ein Eingangssignal ES wird an die Eingänge eines Integrators 100 und einer Periodizitätserkennung 200 geführt. Die Periodizitätserkennung 200 erkennt den Beginn jeder einzelnen Periode des Eingangssignals ES und steuert mittels eines Impulsgebers 400 zum Zeitpunkt des Beginns jeder Periode eine Speichervorrichtung 300 an, welche den zu diesem Zeitpunkt am Ausgang des Integrators 100 ausgegebenen Pegel, welcher den Gleichanteil der letzten vergangenen Periode des Eingangssignals ES repräsentiert, speichert und als Ausgangssignal DC vorhält.

Der Impulsgeber 400 steuert zum Zeitpunkt des Beginns jeder Vollperiode eine Verzögerungsschaltung 500 an, welche mittels einer Triggerschaltung 600 den Integrator 100 zeitlich unmittelbar nach dem Speichern des Ausgangspegels des Integrators 100 in der Speichervorrichtung 300 zurücksetzt (löscht). Die Impulse zur Ansteuerung der Speichervorrichtung 300 und die Impulse zur Rücksetzung des Integrators 100 sind demnach zeitlich unmittelbar aufeinanderfolgend.

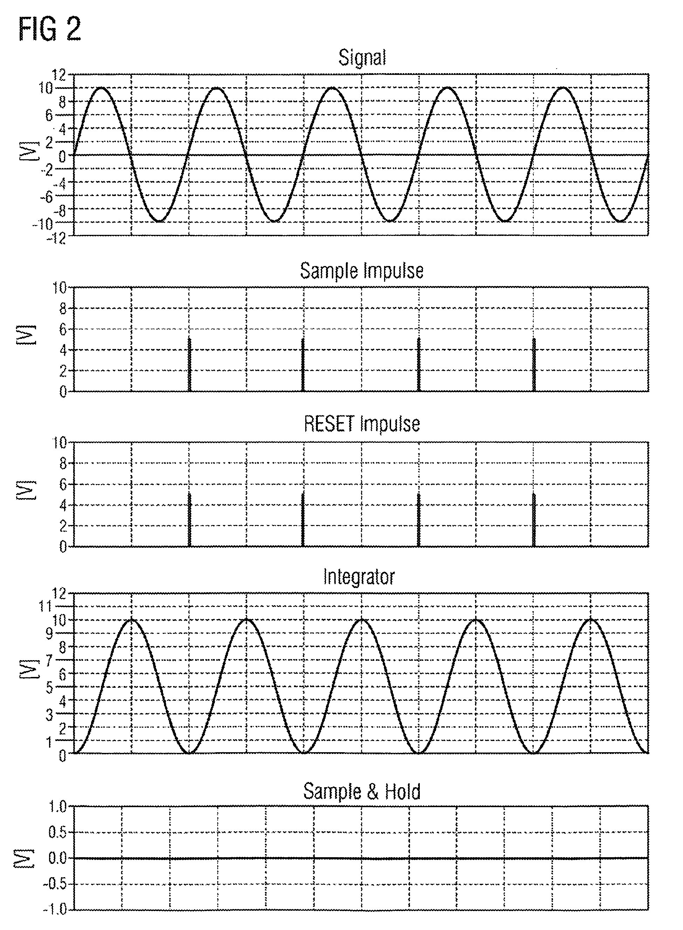

**Fig. 2** zeigt beispielhaft und schematisch die Simulation der Signalverläufe in einer Gleichanteilsbestimmungsschaltung gemäß Fig.1. Ein sinusförmiges Signal ohne Gleichanteil ES bildet das Eingangssignal des Integrators 100 und wird von diesem Integrator 100 über jeweils eine Periode integriert. Das Ausgangssignal des Integrators 100 bildet das Eingangssignal einer Speichervorrichtung 300, welche zu vom Signal Sample Impulse bestimmten Zeitpunkten das Ausgangssignal des Integrators 100 speichert und seinerseits als Ausgangssignal DC (Sample&Hold) zur Verfügung stellt. Weiters sind in Fig. 2 das Signal zur Steuerung der Speichervorrichtung 300 (Sample Impulse) und das Signal zur Rücksetzung des Integrators 100 (RESET Impulse) dargestellt. Das den Gleichanteil des Eingangssignal repräsentierende Ausgangssignal der Speichervorrichtung DC (Sample&Hold) nimmt im dargestellten Beispiel zu jedem Zeitpunkt den Wert Null an.

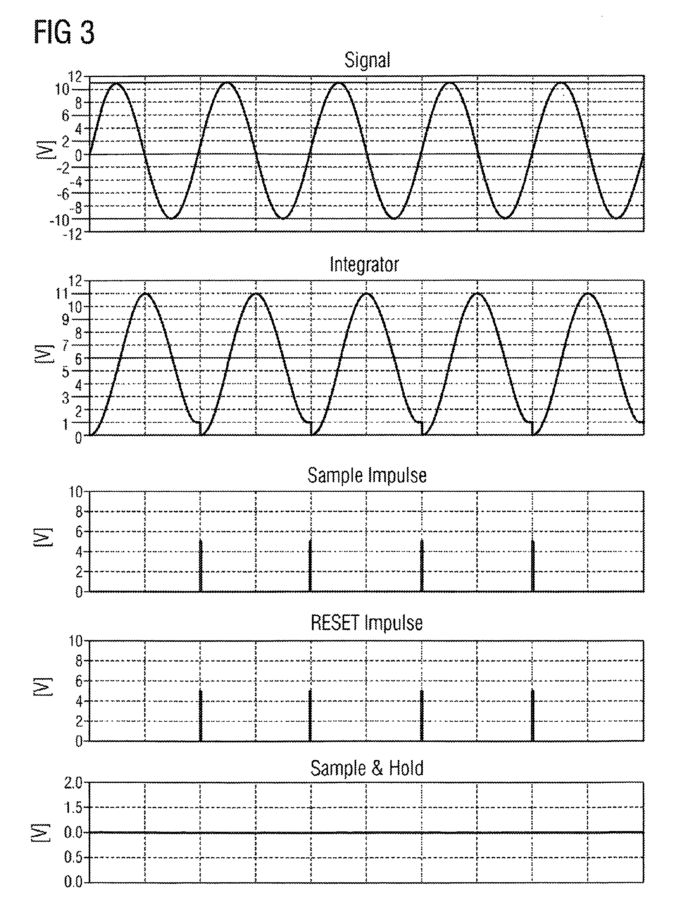

**Fig. 3** zeigt beispielhaft und schematisch die Simulation der Signalverläufe in einer Gleichanteilsbestimmungsschaltung gemäß Fig.1 bei einem sinusförmigen Eingangssignal ES mit positivem Gleichanteil. Im dargestellten Beispiel ist zum Zeitpunkt des Endes jeder Periode des Eingangssignals ein positiver Wert am Ausgang des Integrators 100 anliegend, welcher von der Speichervorrichtung 300 abgespeichert wird.

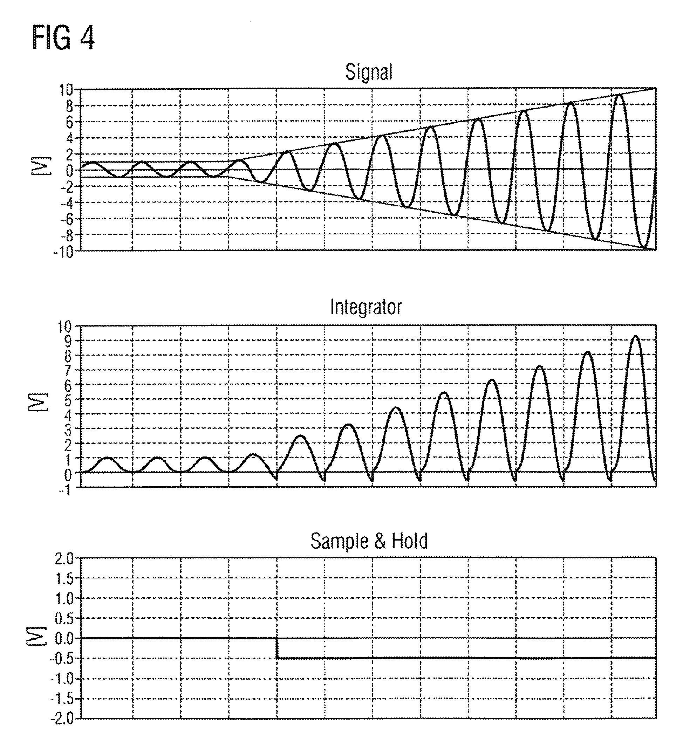

**Fig. 4** zeigt beispielhaft und schematisch die Simulation der Signalverläufe in einer Gleichanteilsbestimmungsschaltung gemäß Fig.1 bei einem sinusförmigen Eingangssignal ES ohne Gleichanteil mit ansteigender Amplitude. Es ist ein sinusförmiges Eingangssignal ES dargestellt, welches ab einem Zeitpunkt einen mit konstanter Rate ansteigenden Pegel aufweist. Dadurch besitzt ab diesem Zeitpunkt jede Halbperiode einen größeren Betrag der Amplitude als die vorherige Halbperiode. Somit integriert der Integrator 100 ein Signal, dessen erste Halbperiode einen geringern Betrag aufweist als die zweite Halbperiode mit entgegensetzter Polarität. Im gegenständlichen Beispiel stellt sich dadurch ab dem Zeitpunkt des Anstiegs des Pegels des Eingangssignals ein negativer Wert am Ausgang des Integrators 100 ein. Die Signale zur Ansteuerung der Speichervorrichtung 300 und die Signale zum Rücksetzen des Integrators 100 sind zur Vereinfachung nicht mehr dargestellt.

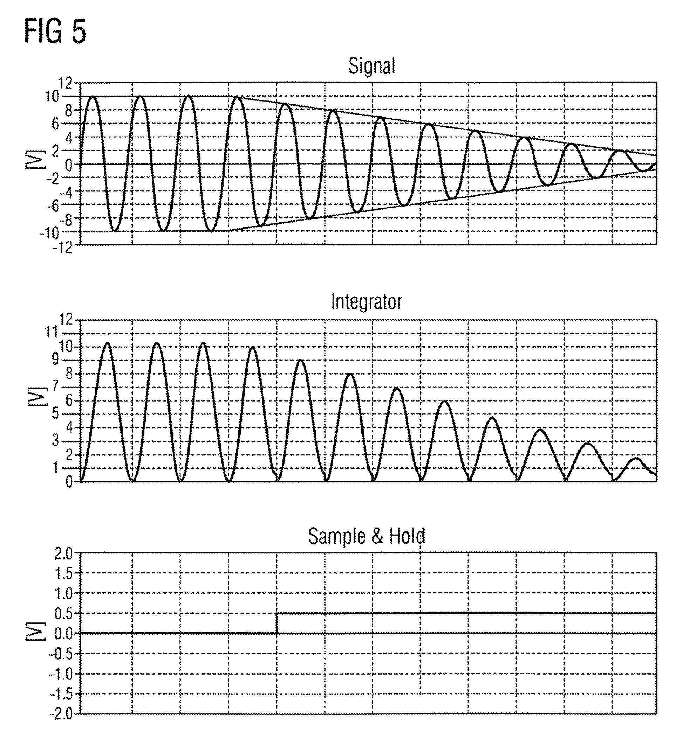

**Fig. 5** zeigt beispielhaft und schematisch die Simulation der Signalverläufe in einer Gleichanteilsbestimmungsschaltung gemäß Fig.1 bei einem sinusförmigen Eingangssignal ES ohne Gleichanteil mit abfallender Amplitude.

In diesem Fall stellt sich dadurch ab dem Zeitpunkt des Abfalls des Pegels des Eingangssignals ES ein positiver Wert am Ausgang des Integrators 100 und somit auch als Gleichwert DC ein.

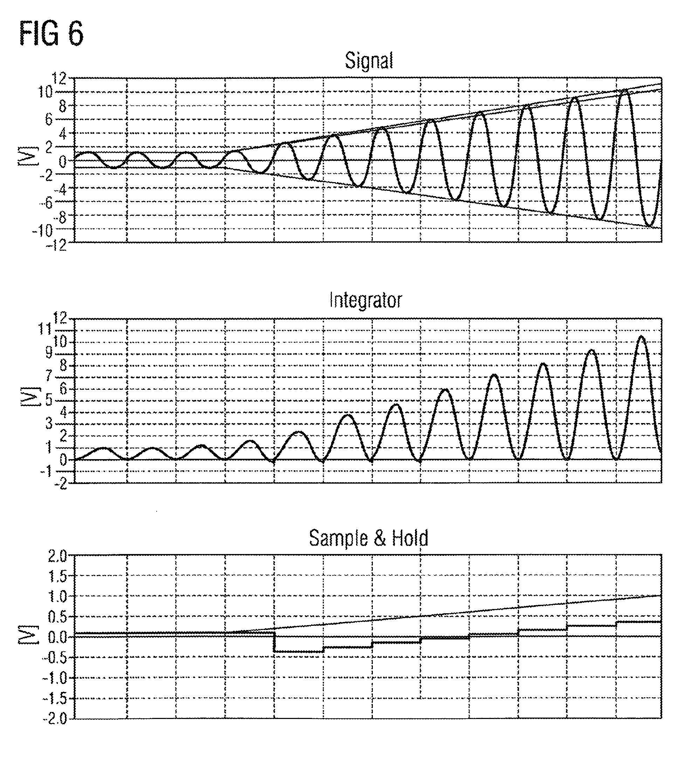

**Fig. 6** zeigt beispielhaft und schematisch die Simulation der Signalverläufe in einer Gleichanteilsbestimmungsschaltung gemäß Fig.1 bei einem sinusförmigen Eingangssignal ES mit einem Gleichanteil und mit ansteigender Amplitude. Es ist ein Eingangssignal ES, welches einen Gleichanteil von 10% der Amplitude aufweist und ab einem Zeitpunkt einen mit konstanter Rate ansteigenden Pegel aufweist, dargestellt. Mit diesem Eingangssignal ES erzeugt die

Gleichanteilsbestimmungsschaltung gemäß Fig.1 ein Ausgangssignal DC, welches bis zum Zeitpunkt des Pegelanstiegs dem Gleichanteil des Eingangssignals ES entspricht. Zum Zeitpunkt des Beginns des Pegelanstiegs fällt im gezeigten Beispiel das Ausgangssignal DC auf negative Werte ab und steigt danach nach jeder Vollperiode an.

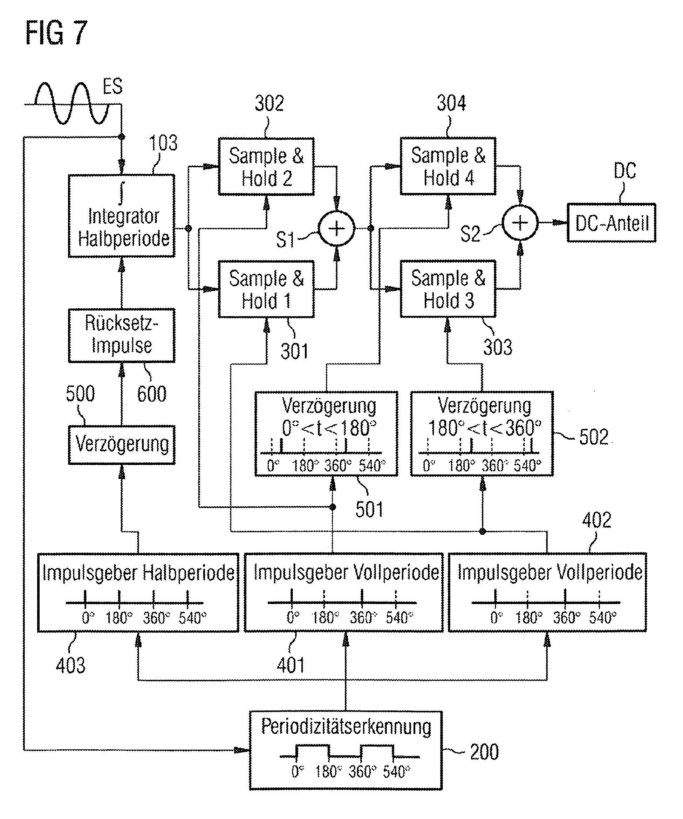

**Fig. 7** zeigt beispielhaft und schematisch ein Blockschaltbild einer Gleichanteilsbestimmungsschaltung nach dem Halbwellenintegrationsverfahren.

Ein Eingangssignal ES wird an die Eingänge eines Integrators 103 und einer Periodizitätserkennung 200 geführt. Der Integrator 103 integriert das Eingangssignal ES jeweils für eine Halbperiode des Eingangssignals ES und wird unmittelbar nach dem Ende jeder Halbperiode rückgesetzt (gelöscht). Das Ausgangssignal des Integrators 103 wird an eine erste Speichervorrichtung 302 und an eine zweite Speichervorrichtung 301 geführt und von diesen Speichervorrichtungen 301, 302 gespeichert, wobei die erste Speichervorrichtung 302 das Ausgangssignal des Integrators 103 zum Zeitpunkt des Beginns jeder Vollperiode und die zweite Speichervorrichtung 301 das Ausgangssignal des Integrators 103 zum Zeitpunkt des Beginns jeder um eine Halbperiode verschobene Vollperiode des Eingangssignals ES abspeichert. Die in den beiden Speichervorrichtungen 301, 302 gespeicherten Pegel werden in einer ersten Summierschaltung S1 addiert, dieses Summensignal DC repräsentiert den Gleichanteil des Eingangssignals ES. Die Ansteuerung der Speichervorrichtungen 301, 302 erfolgt mittels zweier Impulsgeber 401, 402, wobei ein Impulsgeber 401 zur jeder Beginn jeder Vollperiode des Eingangssignals ES die erste Speichervorrichtung 302 ansteuert und der zweite Impulsgeber 402 zu Beginn jeder dazu zeitlich um eine Halbperiode verschobenen Vollperiode die zweite Speichervorrichtung 301 ansteuert. Ein Impulsgeber 403 setzt den Integrator 103 mittels einer Verzögerungsschaltung 500 und einem Rücksetzimpulsgeber 600 unmittelbar nach dem Ende jeder Halbperiode zurück (löscht den im Integrator 103 gespeicherten Pegel).

Das den Gleichanteil des Eingangssignals ES repräsentierende Ausgangssignal DC wird mittels der zweiten Summierschaltung S2 aus den Ausgangssignalen einer dritten Speichervorrichtung 304 (Sample&Hold 4) und einer vierten Speichervorrichtung 303 (Sample&Hold 3) gebildet. Die Eingangsignale beider weiterer Speichervorrichtungen 303, 304 (Sample&Hold 3, Sample&Hold 4) bildet das durch Summierung der Ausgangssignale der ersten Speichervorrichtung 302 (Sample&Hold 2) und zweiten Speichervorrichtung 301 (Sample&Hold 1) gebildete Signal. Die dritte Speichervorrichtungen 304 wird in jeder Periode des Eingangssignals ES der Gleichanteilsbestimmungsschaltung zu einem beliebigen Zeitpunkt innerhalb der ersten Halbperiode des Eingangssignals ES der Gleichanteilsbestimmungsschaltung angesteuert und speichert ihr zugeordnetes Eingangssignal zu diesem Zeitpunkt ab. Die vierte Speichervorrichtungen 303 wird zu einem dazu um zeitlich eine Halbperiode des Eingangssignals ES der Gleichanteilsbestimmungsschaltung verschobenen Zeitpunkt (in der zweiten Halbperiode) angesteuert und speichert ihr zugeordnetes Eingangssignal zu diesem Zeitpunkt ab. Die Ansteuerung der dritten und vierten Speichervorrichtung 304, 303 (Sample&Hold 4, Sample&Hold 3) wird von zwei Verzögerungsschaltungen 501, 502 vorgenommen, welche jeweils von einem der Impulsgeber 401, 402 angesteuert werden.

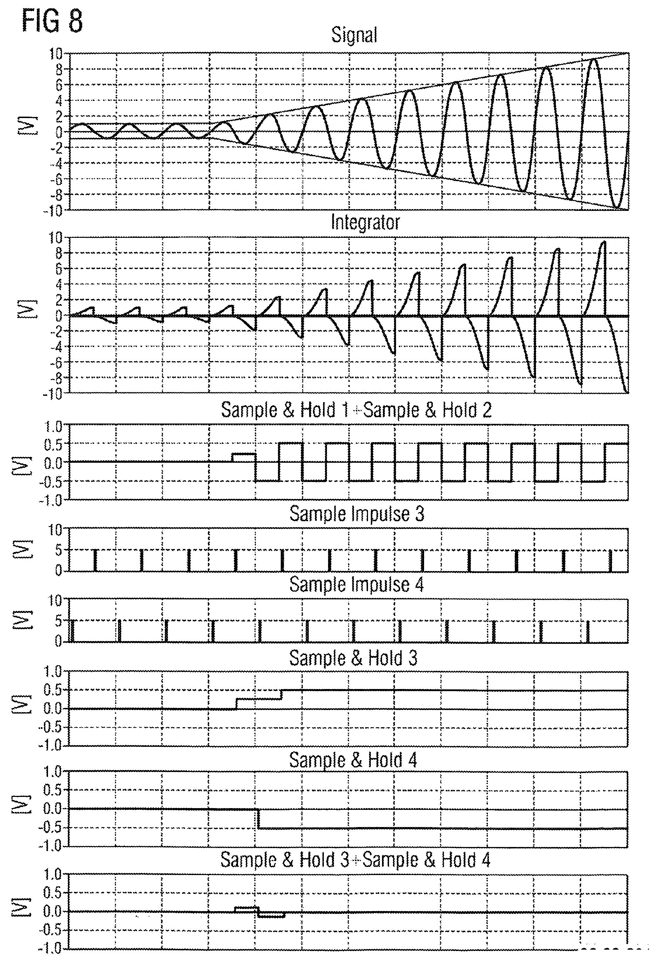

**Fig. 8** zeigt beispielhaft und schematisch die Simulation der Signalverläufe in einer erfindungsgemäßen Gleichanteilsbestimmungsschaltung nach einem Halbwellenintegrationsverfahren mit zwei zusätzlichen Speichervorrichtungen gemäß Fig. 7 bei einem Eingangsignal ES mit ansteigender Amplitude. Es ist ein sinusförmiges periodisches Eingangssignal ES, welches ab einem Zeitpunkt einen mit konstanter Rate ansteigenden Pegel aufweist, dargestellt. Das durch Summierung der Ausgangssignale der ersten und zweiten Speichervorrichtung 302, 301 (Sample&Hold 2, Sample&Hold 1) gebildete Signal zeigt einen rechteckförmigen Verlauf. Das Ausgangssignal DC der Gleichanteilsbestimmungsschaltung nach einem Halbwellenintegrationsverfahren mit zwei zusätzlichen Speichervorrichtungen, welches durch Summierung der dritten und vierten Speichervorrichtung 304, 303 (Sample&Hold 4, Sample&Hold 3) gebildet wird, zeigt bis auf eine kurze Einschwingphase den Wert Null.

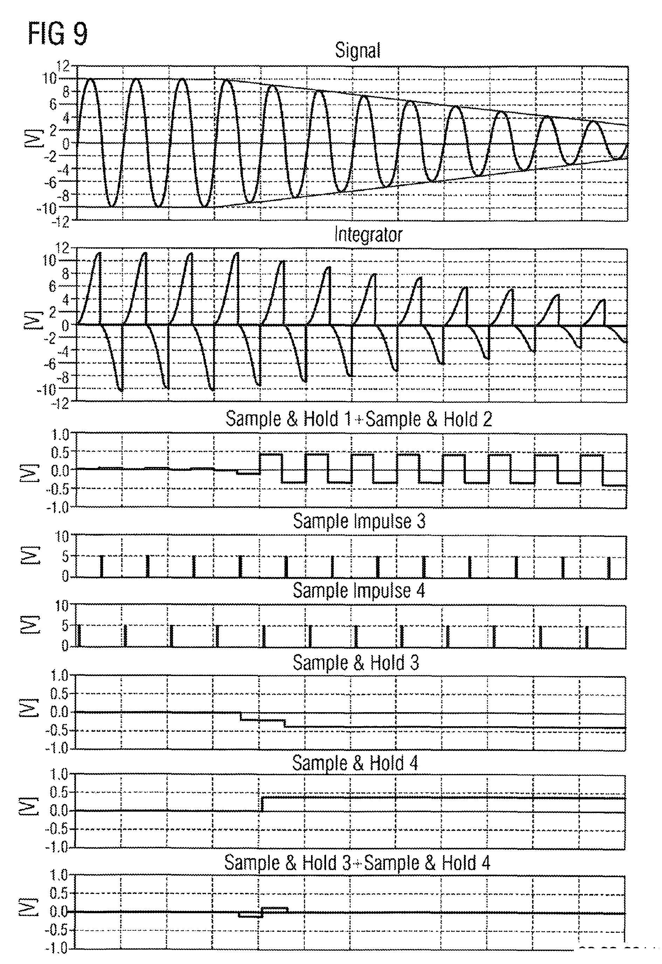

**Fig. 9** zeigt beispielhaft und schematisch die Simulation der Signalverläufe in einer erfindungsgemäßen Gleichanteilsbestimmungsschaltung nach einem Halbwellenintegrationsverfahren mit zwei zusätzlichen Speichervorrichtungen gemäß Fig. 7 bei einem Eingangsignal ES mit abfallender Amplitude. Es ist ein sinusförmiges periodisches Eingangssignal, welches ab einem Zeitpunkt einen mit konstanter Rate abfallenden Pegel aufweist, dargestellt. In diesem Fall zeigt das Ausgangssignal DC der Gleichanteilsbestimmungsschaltung nach einem Halbwellenintegrationsverfahren mit zwei zusätzlichen Speichervorrichtungen, welches durch Summierung der dritten und vierten Speichervorrichtung 304, 303 (Sample&Hold 4, Sample&Hold 3) gebildet wird, zeigt bis auf eine kurze Einschwingphase den Wert Null.

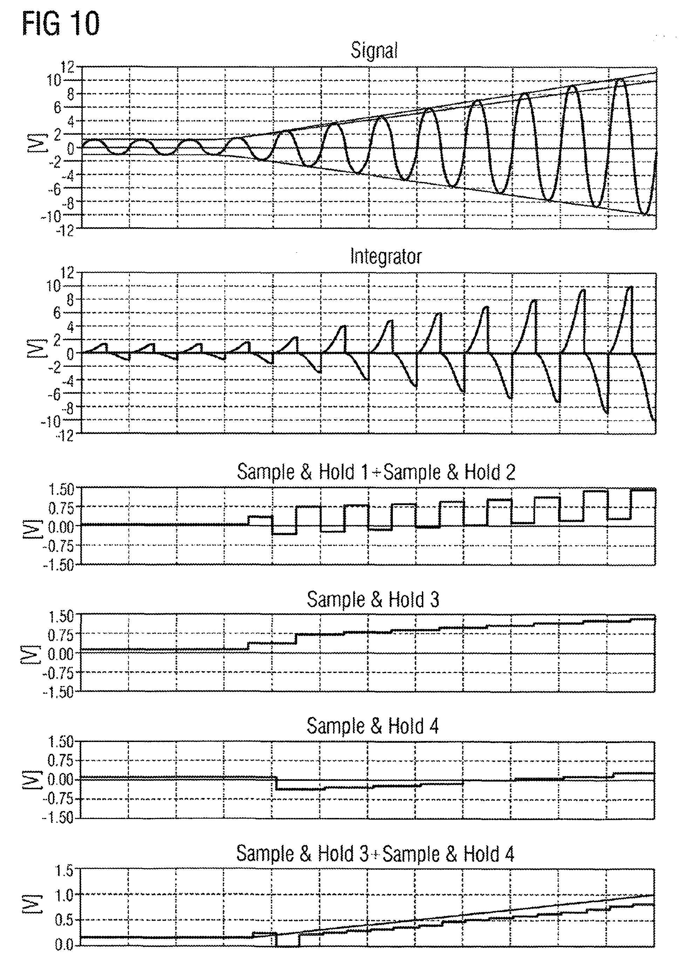

**Fig. 10** zeigt beispielhaft und schematisch die Simulation der Signalverläufe in einer erfindungsgemäßen Gleichanteilsbestimmungsschaltung nach einem Halbwellenintegrationsverfahren mit zwei zusätzlichen Speichervorrichtungen gemäß Fig. 7 bei einem Eingangsignal ES mit ansteigender Amplitude und einem Gleichanteil von 10% der Amplitude. Das Ausgangssignal DC, welches durch Summierung der dritten und vierten Speichervorrichtung 304, 303 (Sample&Hold 4, Sample&Hold 3) gebildet wird, folgt bis auf eine kurze Einschwingphase dem Wert des Gleichanteils des Eingangssignals ES.

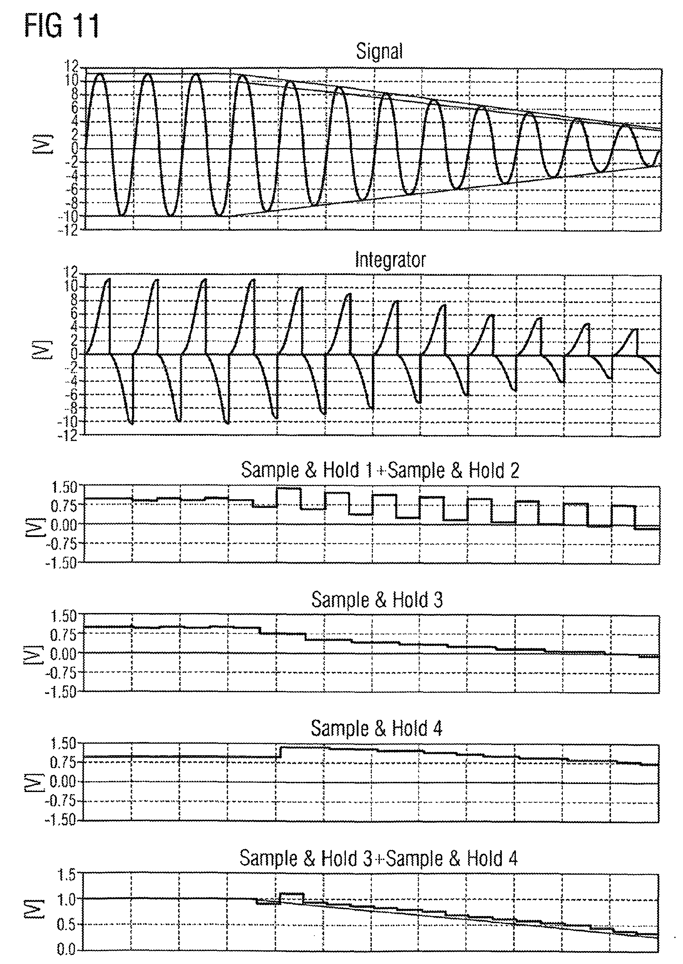

**Fig. 11** zeigt beispielhaft und schematisch die Simulation der Signalverläufe in einer erfindungsgemäßen Gleichanteilsbestimmungsschaltung nach einem Halbwellenintegrationsverfahren mit zwei zusätzlichen Speichervorrichtungen gemäß Fig. 7 bei einem Eingangsignal ES mit abfallender Amplitude und einem Gleichanteil von 10% der Amplitude.

Das Ausgangssignal DC, welches durch Summierung der dritten und vierten Speichervorrichtung 304, 303 (Sample&Hold 4, Sample&Hold 3) gebildet wird, folgt bis auf eine kurze Einschwingphase dem Wert des Gleichanteils des Eingangssignals ES.

**Fig. 12** zeigt beispielhaft und schematisch ein Blockschaltbild einer erfindungsgemäßen Gleichanteilsbestimmungsschaltung nach dem Halbwellenintegrationsverfahren mit zwei zusätzlichen Speichervorrichtungen wie in Fig. 7, erweitert um Mittel zur Unterdrückung des Einschwingimpulses.

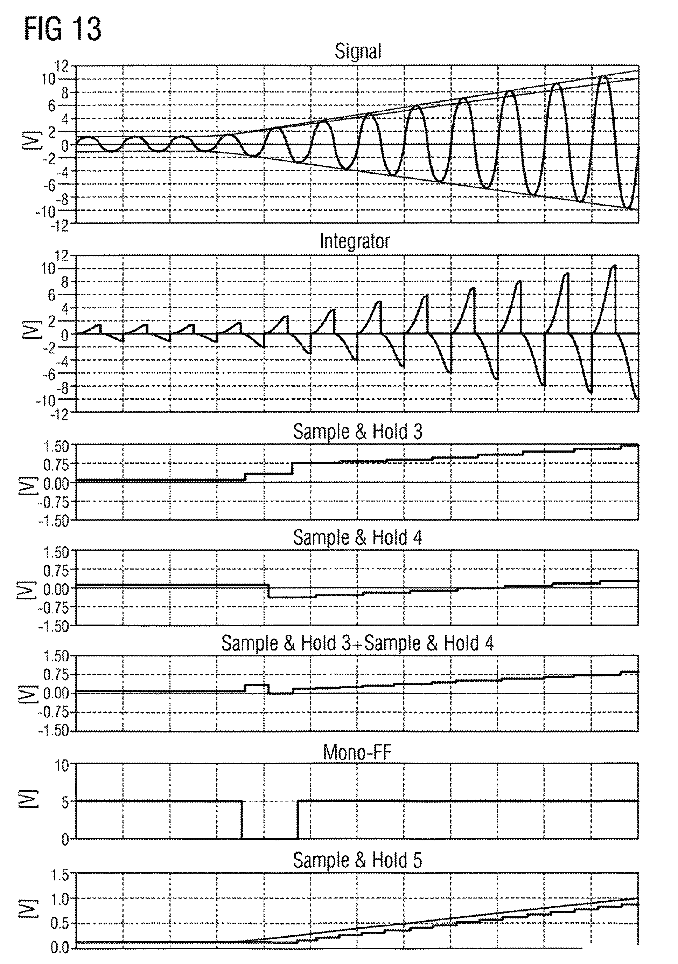

**Fig. 13** zeigt beispielhaft und schematisch die Simulation der Signalverläufe in einer erfindungsgemäßen Gleichanteilsbestimmungsschaltung nach einem Halbwellenintegrationsverfahren mit zwei zusätzlichen Speichervorrichtungen und Mitteln zur Unterdrückung des Einschwingimpulses gemäß Fig. 7 bei einem Eingangsignal ES mit ansteigender Amplitude und einem Gleichanteil von 10% der Amplitude.

**Liste der Bezeichnungen**

| | |
|---|---|
| ES | Eingangssignal |
| DC | Gleichwert |
| S | Summierung |
| S1 | erste Summierung |
| S2 | zweite Summierung |
| 100 | Integrator Vollperiode |
| 200 | Periodizitätserkennung |
| 300 | Speichervorrichtung |
| 400 | Impulsgeber Vollperiode |
| 500 | Verzögerungsschaltung Rücksetzung Integrator |
| 501 | Verzögerungsschaltung Speichervorrichtung 1 |
| 502 | Verzögerungsschaltung Speichervorrichtung 2 |
| 600 | Rücksetzimpulsgeber |
| 103 | Integrator Halbperiode |

301 Speichervorrichtung 1
302 Speichervorrichtung 2
303 Speichervorrichtung 3
304 Speichervorrichtung 4
305 Speichervorrichtung 5
401 Impulsgeber Vollperiode 1
402 Impulsgeber Vollperiode 2
403 Impulsgeber Halbperiode
700 Vergleicherschaltung (Komparator)
800 Zeitglied (Mono Flip Flop)

**Patentansprüche**

1. Halbwellenverfahren zur Bestimmung des Gleichanteils eines periodischen Eingangssignals (ES) wobei das periodische Eingangssignal (ES) einem Integrator (103) und einer Periodizitätserkennung (200) zugeführt wird, und der Integrator (103) das periodische Eingangssignal (ES) über jeweils eine Halbperiode integriert, mit folgenden Verfahrensschritten:

   - Zuführen des Ausgangssignals des Integrators (103) an eine erste Sample&Hold Speichervorrichtung (302) und Abspeichern dieses Signalwerts in dieser ersten Speichervorrichtung (302) zu Beginn jeder Vollperiode des periodischen Signals (ES),
   - Zuführen des Ausgangssignals des Integrators (103) an eine zweite Sample&Hold Speichervorrichtung (301) und Abspeichern dieses Signalwerts in dieser zweiten Speichervorrichtung (301) zu Beginn jeder um eine halbe Periodendauer verschobenen Vollperiode des periodischen Signals (ES),
   - Summierung der in den beiden vorgehenden Verfahrensschritten erfassten Signalwerte in einer ersten Summierung (S1),

   **gekennzeichnet durch** folgende weitere Verfahrensschritte:

   - Zuführen dieses ersten Summensignalwerts an eine dritte Sample&Hold Speichervorrichtung (304) und Abspeichern dieses ersten Summensignalwerts in dieser dritten Speichervorrichtung (304) zu Beginn jeder, um einen Zeitraum zwischen Null und einer halben Periodendauer verschobenen Vollperiode des periodischen Signals (ES),
   - Zuführen dieses ersten Summensignalwerts an eine vierte Sample&Hold Speichervorrichtung (303) und Abspeichern dieses ersten Summensignalwerts in dieser vierten Speichervorrichtung (303) zu Beginn jeder, um einen Zeitraum zwischen einer halben und einer ganzen Periodendauer verschobenen Vollperiode des periodischen Signals (ES),

   - Summierung der in den beiden vorgehenden Verfahrensschritten erfassten Summensignalwerte in einer zweiten Summierung (S2) und Ausgeben dieses Summensignalwerts als Gleichwert (DC) des periodischen Eingangssignals (ES).

2. Halbwellenverfahren zur Bestimmung des Gleichanteils eines periodischen Eingangssignals (ES) mit Unterdrückung der Einschwingphase, wobei das periodische Eingangssignal (ES) einem Integrator (103) und einer Periodizitätserkennung (200) zugeführt wird, und der Integrator (103) das periodische Eingangssignal (ES) über jeweils eine Halbperiode integriert, mit folgenden Verfahrensschritten:

   - Zuführen des Ausgangssignals des Integrators (103) an eine erste Sample&Hold Speichervorrichtung (302) und Abspeichern dieses Signalwerts in dieser ersten Speichervorrichtung (302) zu Beginn jeder Vollperiode des periodischen Signals (ES),
   - Zuführen des Ausgangssignals des Integrators (103) an eine zweite Sample&Hold Speichervorrichtung (301) und Abspeichern dieses Signalwerts in dieser zweiten Speichervorrichtung (301) zu Beginn jeder um eine halbe Periodendauer verschobenen Vollperiode des periodischen Signals (ES),
   - Summierung der in den beiden vorgehenden Verfahrensschritten abgespeicherten Signalwerte in einer ersten Summierung (S1),

   **gekennzeichnet durch** folgende weitere Verfahrensschritte:

   - Zuführen dieses ersten Summensignalwerts an eine dritte Sample&Hold Speichervorrichtung (304) und Abspeichern dieses Summensignalwerts in dieser dritten Speichervorrichtung (304) zu Beginn jeder, um einen Zeitraum zwischen Null und einer halben Periodendauer verschobenen Vollperiode des periodischen Signals (ES),
   - Zuführen dieses ersten Summensignalwerts an eine vierte Sample&Hold Speichervorrichtung (303) und Abspeichern dieses Summensignalwerts in dieser vierten Speichervorrichtung (303) zu Beginn jeder, um einen Zeitraum zwischen einer halben und einer ganzen Periodendauer verschobenen Vollperiode des periodischen Signals (ES),
   - Summierung der in den beiden vorgehenden Verfahrensschritten abgespeicherte Signalwerte in einer zweiten Summierung (S2) und zuführen dieses zweiten Summensignalwerts an eine fünfte Sample&Hold Speichervorrichtung (305) und Abspeichern dieses Signalwerts in dieser fünften Speichervorrichtung (305)

- Zuführen der in der dritten Speichervorrichtung (304) und der vierten Speichervorrichtung (303) abgespeicherten Signalwerte an eine Vergleicherschaltung (700) und Auslösen eines Zeitgliedes (800) **durch** die Vergleicherschaltung (700) bei unterschiedlichen Pegeln der in der dritten Speichervorrichtung (304) und der vierten Speichervorrichtung (303) abgespeicherten Signalwerte,

- Ausgeben des in der fünften Speichervorrichtung (305) abgespeicherten zweiten Summensignalwertes als Gleichwert (DC) des periodischen Eingangssignals (ES), wobei während der Laufzeit des Zeitgliedes (800) das Abspeichern neuer Signalwerte in der fünften Speichervorrichtung (305) unterdrückt wird und der letzte vor Beginn der Laufzeit des Zeitgliedes (800) abgespeicherte Signalwert für die Laufzeit des Zeitgliedes weiterhin als Gleichwert (DC) des periodischen Eingangssignals (ES) ausgegeben wird.

## Claims

1. Half-wave method for determining the offset of a periodic input signal (ES) with the periodic input signal (ES) being fed to an integrator (103) and to a periodicity recognition unit (200), and the integrator (103) integrating the periodic input signal (ES) over a respective half period, with the following method steps:

   - Feeding the output signal of the integrator (103) to a first Sample&Hold memory device (302) and storing this signal value in this first memory device (302) at the beginning of each full period of the periodic signal (ES),
   - Feeding the output signal of the integrator (103) to a second Sample&Hold memory device (301) and storing this signal value in this second memory device (301) at the beginning of each full period of the periodic signal (ES) offset by a half period,
   - Summing the signal values detected in the two preceding method steps in a first summation (S1),

   **characterised by** the following further method steps:

   - Feeding this first sum signal value to a third Sample&Hold memory device (304) and storing this first sum signal value in this third memory device (304) at the beginning of each full period of the periodic signal (ES) offset by a time of between zero and a half period duration,
   - Feeding this first sum signal value to a fourth Sample&Hold memory device (303) and storing this first sum signal value in this fourth memory device (303) at the beginning of each full period of the periodic signal (ES) offset by a time of between a half and a full period duration,

   - Summing the sum signal values detected in the two preceding method steps in a second summation (S2) and outputting this sum signal value as an offset value (DC) of the periodic input signal (ES).

2. Half-wave method for determining the offset of a periodic input signal (ES) with suppression of the synchronisation phase, with the periodic input signal (ES) being fed to an integrator (103) and a periodicity detection unit (200), and the integrator (103) integrating the periodic input signal (ES) over a respective half period, with the following method steps:

   - Feeding the output signal of the integrator (103) to a first Sample&Hold memory device (302) and storing this signal value in this first memory device (302) at the beginning of each full period of the periodic signal (ES),
   - Feeding the output signal of the integrator (103) to a second Sample&Hold memory device (301) and storing this signal value in this second memory device (301) at the beginning of each full period of the periodic signal (ES) offset by a half period duration,
   - Summing the signal values stored in the two preceding method steps in a first summation (S1),

   **characterised by** the following further method steps:

   - Feeding this first sum signal value to a third Sample&Hold memory device (304) and storing this sum signal value in this third memory device (304) at the beginning of each full period of the periodic signal (ES) offset by a time of between zero and a half period duration,
   - Feeding this first sum signal value to a fourth Sample&Hold memory device (303) and storing this sum signal value in this fourth memory device (303) at the beginning of each full period of the periodic signal (ES) offset by a time of between a half and a full period duration,
   - Summing the signal values stored in the two preceding method steps in a second summation (S2) and feeding this second sum signal value to a fifth Sample&Hold memory device (305) and storing this signal value in this fifth memory device (305)
   - Feeding the signal values stored in the third memory device (304) and the fourth memory device (303) to a comparator circuit (700) and triggering of a timing element (800) by the comparator circuit (700) for different levels of the signal values stored in the third memory device (304) and the fourth memory device (303),

- Outputting the second sum signal value stored in the fifth memory device (305) as an offset value (DC) of the periodic input signal (ES), with storage of new signal values in the fifth memory device (305) being suppressed while the timing element (800) is running and the last signal value stored before the beginning of the runtime of the timing element (800) continuing to be output for the runtime of the timing element as offset value (DC) of the periodic input signal (ES).

**Revendications**

1. Procédé demi-onde de détermination de la composante continue d'un signal (ES) d'entrée périodique, dans lequel le signal (ES) d'entrée périodique est envoyé à un intégrateur (103) et à une détection (200) de périodicité et l'intégrateur (103) intègre le signal (ES) d'entrée périodique sur respectivement une demi-période, comprenant les stades de procédé suivants :

    - on envoie le signal de sortie de l'intégrateur (103) à un premier dispositif (302) de mémorisation échantillonneur bloqueur et on mémorise cette valeur de signal dans ce premier dispositif (302) de mémorisation au début de chaque période complète du signal (ES) périodique,
    - on envoie le signal de sortie de l'intégrateur (103) à un deuxième dispositif (301) de mémorisation échantillonneur bloqueur et on mémorise cette valeur de signal dans ce deuxième dispositif (301) de mémorisation au début de chaque période complète, décalée d'une demi-durée de période, du signal (ES) périodique,
    - on somme les valeurs de signal détectées dans les deux stades de procédé précédents dans une première sommation (S1),

    **caractérisé par** les autres stades de procédé suivants :

    - on envoie cette première valeur de signal de somme à un troisième dispositif (304) de mémorisation échantillonneur bloqueur et on mémorise cette première valeur de signal de somme dans ce troisième dispositif (304) de mémorisation au début de chaque période complète, décalée d'un laps de temps entre zéro et une demi-durée de période, du signal (ES) périodique,
    - on envoie cette première valeur de signal de somme à un quatrième dispositif (303) de mémorisation échantillonneur bloqueur et on mémorise cette première valeur de signal de somme dans ce quatrième dispositif (303) de mémorisation au début de chaque période complète, décalée d'un laps de temps entre une demi-durée de période et une durée complète de période, du signal (ES) périodique,
    - on somme les valeurs de signal de somme détectées dans les deux stades précédents du procédé dans une deuxième sommation (S2) et on émet cette valeur de signal de somme comme valeur d'essai continue du signal (ES) d'entrée périodique.

2. Procédé demi-onde de détermination de la composante continue d'un signal (ES) d'entrée périodique avec supression de la phase d'harmonique, dans lequel on envoie le signal (ES) d'entrée périodique à un intégrateur (103) et à une détection (200) de la périodicité et l'intégrateur (103) intègre le signal (ES) d'entrée périodique sur respectivement une demi-période, comprenant les stades de procédé suivants :

    - on envoie le signal de sortie de l'intégrateur (103) à un premier dispositif (302) de mémorisation échantillonneur bloqueur et on mémorise cette valeur de signal dans ce premier dispositif (302) de mémorisation au début de chaque période complète du signal (ES) périodique,
    - on envoie le signal de sortie de l'intégrateur (103) à un deuxième dispositif (301) de mémorisation échantillonneur bloqueur et on mémorise cette valeur de signal dans ce deuxième dispositif (301) de mémorisation au début de chaque période complète, décalée d'une demi-durée de période, du signal (ES) périodique,
    - on somme les valeurs de signal détectées dans les deux stades de procédé précédents dans une première sommation (S1),

    **caractérisé par** les autres stades de procédé suivants :

    - on envoie cette première valeur de signal de somme à un troisième dispositif (304) de mémorisation échantillonneur bloqueur et on mémorise cette première valeur de signal de somme dans ce troisième dispositif (304) de mémorisation au début de chaque période complète, décalée d'un laps de temps entre zéro et une demi-durée de période, du signal (ES) périodique,
    - on envoie cette première valeur de signal de somme à un quatrième dispositif (303) de mémorisation échantillonneur bloqueur et on mémorise cette première valeur de signal de somme dans ce quatrième dispositif (303) de mémorisation au début de chaque période complète, décalée d'un laps de temps entre une demi-durée de période et une durée complète de période, du signal ( ES ) périodique,

- on somme les valeurs de signal mémorisées dans les deux stades de procédé précédents dans une deuxième sommation ( S2 ) et on envoie cette deuxième valeur de signal de somme à un cinquième dispositif (305) de mémorisation échantillonneur bloqueur et on mémorise cette valeur de signal dans ce cinquième dispositif ( 305 ) de mémorisation,

- on envoie les valeurs de signal mémorisées dans le troisième dispositif ( 304 ) de mémorisation et dans le quatrième dispositif ( 303 ) de mémorisation à un circuit ( 700 ) de comparateur et on déclenche un temporisateur ( 800 ) par le circuit ( 700 ) de comparaison, s'il y a des niveaux différents des valeurs de signal mémorisées dans le troisième dispositif ( 304 ) de mémorisation et dans le quatrième dispositif ( 303 ) de mémorisation,

- on émet la deuxième valeur de signal de somme mémorisée dans le cinquième dispositif ( 305 ) de mémorisation comme valeur d'essai continue du signal (ES) d'entrée périodique, dans lequel, pendant le temps de fonctionnement du temporisateur (800), on supprime la mémorisation de nouvelles valeurs de signal dans le cinquième dispositif ( 305) de mémorisation et on continue à émettre comme valeurs d'essai continues du signal (ES) d'entrée périodique pour le temps de fonctionnement du temporisateur, la dernière valeur de signal mémorisée avant le début du temps de fonctionnement du temporisateur ( 800 ).

# FIG 1

ES

100

300

DC

Integrator
Halbperiode

Sample &
Hold

DC-Anteil

Rücksetz-
Impulse

600

500

Impulsgeber Vollperiode

400

Verzögerung

0°   180°   360°   540°

Periodizitätserkennung

0°   180°   360°   540°

200

# FIG 2

Signal

Sample Impulse

RESET Impulse

Integrator

Sample & Hold

# FIG 3

### Signal

### Integrator

### Sample Impulse

### RESET Impulse

### Sample & Hold

# FIG 4

# FIG 5

Signal

Integrator

Sample & Hold

# FIG 6

# FIG 7

# FIG 8

## FIG 9

Signal

Integrator

Sample & Hold 1 + Sample & Hold 2

Sample Impulse 3

Sample Impulse 4

Sample & Hold 3

Sample & Hold 4

Sample & Hold 3 + Sample & Hold 4

# FIG 10

Signal

Integrator

Sample & Hold 1 ÷ Sample & Hold 2

Sample & Hold 3

Sample & Hold 4

Sample & Hold 3 ÷ Sample & Hold 4

20

## FIG 11

Signal

Integrator

Sample & Hold 1 + Sample & Hold 2

Sample & Hold 3

Sample & Hold 4

Sample & Hold 3 + Sample & Hold 4

## FIG 12

## FIG 13

Signal

Integrator

Sample & Hold 3

Sample & Hold 4

Sample & Hold 3+Sample & Hold 4

Mono-FF

Sample & Hold 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 3900796 A1